Europäisches Patentamt

**European Patent Office**

Office européen des brevets

(11) Veröffentlichungsnummer: **0 063 650**
**B1**

(12) **EUROPÄISCHE PATENTSCHRIFT**

(45) Veröffentlichungstag der Patentschrift:
14.08.85

(51) Int. Cl.⁴: **G 01 R 31/28**, G 06 F 11/22

(21) Anmeldenummer: 81110860.4

(22) Anmeldetag: 31.12.81

(54) **Prüfsystem.**

(30) Priorität: 23.04.81 DE 3116079

(73) Patentinhaber: **ROBERT BOSCH GMBH, Postfach 50,
D-7000 Stuttgart 1 (DE)**

(43) Veröffentlichungstag der Anmeldung:
03.11.82 Patentblatt 82/44

(72) Erfinder: **Fellhauer, Michael, Dipl.-Ing., Straubstrasse 3,
D-7340 Geislingen (DE)**
Erfinder: **Holzinger, Otto, Dr. Dipl.-Phys.,
Sudetenstrasse 45, D-7321 Eschenbach (DE)**
Erfinder: **Vits, Klaus, Herrenbachstrasse 42/1,
D-7336 Uhingen-Baiereck (DE)**
Erfinder: **Wurst, Bert, Dipl.-Ing., Karlstrasse 19,
D-7141 Möglingen (DE)**

(45) Bekanntmachung des Hinweises auf die Patenterteilung:
14.08.85 Patentblatt 85/33

(84) Benannte Vertragsstaaten:
**CH DE FR GB LI**

(56) Entgegenhaltungen:
**W. HILBERG, R. PILOTY "Mikroprozessoren und ihre
Anwendungen" 1. Teil, 1977 R. OLDENBURG VERLAG,
München, Wien Seiten 94, 95
FUNKSCHAU, Heft 2, 1975 ING. WERNER WITTKE
"Halbautomatischer Funktionsprüfer für integreiter
TTL-Schaltungen" Seiten 75-78
Prospekt 6942 A, Firma Hewlett u. Packard, Juli 1980**

## Beschreibung

Die Erfindung geht aus von einem Prüfsystem nach der Gattung des Hauptanspruchs. Prüfsysteme zum Prüfen von elektronischen Baugruppen und Leiterplatten sind bereits bekannt. Solche Prüfsysteme weisen eine zentrale Stromversorgung sowie Einschübe auf, in die Baugruppen mit Mess- und Prüfgeräten einschiebbar sind, so dass die entsprechenden Leiterplatten oder Produkte getestet werden können. Die Baugruppen weisen auf einer Seite Steckverbindungen auf, die in entsprechende Buchsen des Gehäuses eingreifen. Die Buchsen sind untereinander über Datenleitungen verbunden. Einer dieser Baugruppen ist dabei meist ein Rechner zugeordnet, mit dem das Prüfsystem steuerbar ist. Über eine Tastatur wird der Rechner durch eine der bekannten Programmsprachen programmiert, wobei er dann die übrigen Baugruppen, die in das Prüfsystem eingesteckt sind, veranlasst, die entsprechenden Befehle durchzuführen. Weitere Einzelheiten über Prüfsysteme sind beispielsweise dem Prospekt 6942A der Firma Hewlett & Packard, Juli 1980, zu entnehmen. Diese bekannten Prüfsysteme weisen jedoch verschiedene Nachteile auf. Soll eine Baugruppe geprüft werden, so muss man sich vor der Prüfung überzeugen, ob die entsprechenden Baugruppen in das Prüfsystem eingeschoben sind. Weiterhin ist zu beachten, dass bestimmte Baugruppen nur an bestimmten Stellen im Prüfsystem einschiebbar sind. Weiterhin ist von Nachteil, dass zur Bedienung dieser Prüfsysteme nur ausgebildete Personen in der Lage sind, die die jeweils verwendete Programmiersprache beherrschen. Wird das Gerät falsch programmiert, kann dies zur Zerstörung der zu prüfenden Baugruppe führen oder aber das Gerät arbeitet überhaupt nicht. Ein weiterer Nachteil ist, dass jeder Anwendungsfall neu verdrahtet werden muss. Das heisst, von den entsprechenden Anschlusssteckern der Leiterplatte werden Kabel zum Prüfling geführt. Diese Verkabelung ist für jede Prüfung neu anzupassen. Die bekannten Prüfsysteme haben daher den Nachteil, dass sie umständlich zu bedienen sind und unter ungünstigen Umständen den Prüfling zerstören. Die Umrüstezeit des Prüfsystems für einen neuen Prüfling ist weiterhin sehr lang.

Aus dem Buch Mikroprozessoren und ihre Anwendungen, herausgegeben von Wolfgang Hilberg, Robert Piloty, 1. Auflage, Oldenbourg-Verlag GmbH, München, Seite 94, 95, ist es bereits bekannt, bei Nachrichtengeräten eine Selbstprüfung durchzuführen. Dazu müssen die Geräte bzw. die einzelnen Baugruppen so aufgebaut sein, dass sie logische Signale abgeben, die von einem Mikroprozessor zum Selbsttest ausgewertet werden. Abgesehen davon, dass in den Baugruppen bereits Massnahmen getroffen sein müssen, die die logischen Meldungen gestatten, ist die dort gezeigte Anordnung nur zum Selbsttest geeignet, d.h. die Baugruppen müssen an sich bereits funktionsfähig sein, so dass lediglich Veränderungen anzuzeigen sind. Die dort gezeigte Prüfart ist nicht in der Lage, eine Prüfung von bestimmten Baugruppen oder Platinen vorzunehmen, deren Betriebszustand zu Beginn des Tests völlig undefiniert ist. Im übrigen ist es aus Kostengründen bei der Massenherstellung von elektronischen Baugruppen nicht zweckmässig, bereits solche Massnahmen vorzusehen, die eine rein logische Prüfung der Baugruppen gestattet.

Vorteile der Erfindung

Das erfindungsgemässe Prüfsystem mit den kennzeichnenden Merkmalen des Hauptanspruches hat demgegenüber den Vorteil, dass vom Prüfsystem erkannt wird, welche Baugruppen im Prüfsystem eingesteckt sind und an welcher Stelle sie eingesteckt sind. Dadurch ist es möglich, die Baugruppen an beliebiger Stelle im Prüfsystem anzuordnen. Ein weiterer Vorteil ist, dass die das Gerät bedienende Person sich nicht durch Öffnen des Prüfsystems über das Vorhandensein der Baugruppenart informieren muss, sondern dass die Kodierung auslesbar ist.

Durch die in den Unteransprüchen aufgeführten Massnahmen sind vorteilhafte Weiterbildungen und Verbesserungen des im Hauptanspruch angegebenen Prüfsystems möglich. Besonders vorteilhaft ist es, ein Koppelfeld vorzusehen, mit dem alle Baugruppen oder ein Teil der Baugruppen verbunden sind. Durch diese Massnahme wird erreicht, dass die Ein- und Ausgänge der verschiedenen Baugruppen in beliebiger Art und Weise nach aussen schaltbar sind. Weiterhin ist es günstig, das Koppelfeld programmierbar auszugestalten. Dadurch wird erreicht, dass das Koppelfeld über einen Rechner ansteuerbar ist. Weiterhin ist es günstig, einen Prüfstecker vorzusehen, der zumindest teilweise mit den Ausgängen des Koppelfeldes verbunden ist. Diese Massnahme ermöglicht eine vollständige Gestaltungsfreiheit zur Verbindung des Prüfsystems mit dem Prüfling. An beliebige Punkte des Prüfsteckers sind beliebige Ein- und Ausgänge der Baugruppen anschliessbar. Dadurch ist das Prüfsystem in einfacher Art und Weise an die unterschiedlichsten Messaufgaben anpassbar. Weiterhin ist es vorteilhaft, die Baugruppen teilweise direkt mit dem Prüfstecker zu verbinden. Diese Massnahme ist dann vorteilhaft, wenn feststeht, dass das entsprechende Signal immer an derselben Stelle am Prüfstecker benötigt wird oder auftritt. Besonders vorteilhaft ist diese Massnahme, wenn die entsprechende Signalleitung kritische Signale führt, die durch lange Wege leicht verfälschbar sind.

Weiter ist es vorteilhaft, das Prüfsystem mit einer Anzeigevorrichtung zu versehen, die anzeigt, welche Baugruppe bei einer bestimmten Adresse vorhanden ist. Das Anzeigesystem ermöglicht der das Prüfsystem bedienenden Person, mit dem Prüfsystem zu kommunizieren. Besonders vorteilhaft ist es, mit diesem Anzeigesystem aufgrund der Kodierung die Baugruppen auszulesen, die im Prüfsystem eingesteckt sind und zur Prüfung verwendbar sind. Weiterhin ist es günstig, eine Tastatur vorzusehen, bei der mittels Tasten eine bestimmte Funktion einer bestimmten Baugruppe aktivierbar ist. Hierdurch entfällt eine feste Verkabelung, sämtliche Anweisungen werden über die
Tastatur gegeben. Besonders günstig ist es, die
Tasten der Tastatur zu desaktivieren, mit denen
bei der aktivierten Baugruppe keine sinnvollen
Funktionen auslösbar sind. Hierdurch wird erreicht, dass das Prüfsystem nicht fehlerhaft arbeitet. Eine Fehlbedienung des Prüfsystems ist damit
ausgeschlossen. Es ist auch günstig, beim Betätigen einer desaktivierten Taste ein Warnsignal abzugeben. Der Bedienende wird dadurch darauf
aufmerksam gemacht, dass er eine falsche Funktion auslösen wollte, und er einen entsprechenden Befehl richtig wiederholen muss. Es ist günstig, sämtliche Funktionen von einem Rechner
zentral zu steuern. Dadurch wird das Prüfsystem
insgesamt besonders kostengünstig.

Das Prüfsystem weist vorteilhafterweise einen
Festwertspeicher auf, in dem sämtliche festen Informationen abgespeichert sind. Dadurch wird
erreicht, dass sich die Bedienung des Gerätes vereinfacht, da dadurch der Rechner in die Lage versetzt wird, entsprechende Tasten der Tastatur zu
sperren oder den vorhandenen jeweils aktuellen
Befehlsvorrat auf der Anzeigevorrichtung anzuzeigen. Der Festwertspeicher ist vorteilhafterweise auswechselbar zu gestalten, so dass das
Prüfsystem an den Stand der Technik anpassbar
ist oder dass der Festwertspeicher auswechselbar
ist, wenn aus ihm fremdsprachige Informationen
auslesbar sein sollten. Weiterhin ist es günstig,
wenn beim Einschalten des Prüfsystems die Baugruppen einen Eigentest durchführen. Dadurch
wird erreicht, dass die Baugruppen immer in einem ordnungsgemässen und betriebssicheren
Zustand sind. Hierbei ist es günstig, wenn das Ergebnis des Eigentests der Baugruppe als Datenbit
auslesbar ist. Dieses Datenbit ist dabei vorteilhafterweise an die Kodierung der Baugruppe anzuhängen, so dass die bedienende Person über den
Zustand der entsprechenden Baugruppe jederzeit
informiert ist. Fehler bei der Funktion der Baugruppe sind somit rechtzeitig erkennbar, bevor
der Prüfling zerstört ist.

In einer weiteren Ausgestaltung der Erfindung
ist es vorteilhaft, beim Aufruf einer Baugruppe der
Reihe nach die Eigenschaften, die Anordnung des
Eingangs- und/oder Ausgangs, die Betriebsart
und der Betriebsbereich oder Teile davon auf der
Anzeigevorrichtung anzuzeigen sind. Diese
Massnahme dient ebenfalls zur Verhinderung einer Zerstörung des Prüfsystems oder des Prüflings. Die das Prüfsystem bedienende Person
wird so durch das Prüfsystem selbsttätig eingewiesen, wobei das Prüfsystem automatisch die
wesentlichen Daten der Baugruppe anzeigt. Sind
in einem oder mehreren Bereichen verschiedene
Daten möglich und einstellbar, so ist es vorteilhaft, diese Datenauswahl anzuzeigen und mittels
der Tastatur auswählbar zu gestalten.

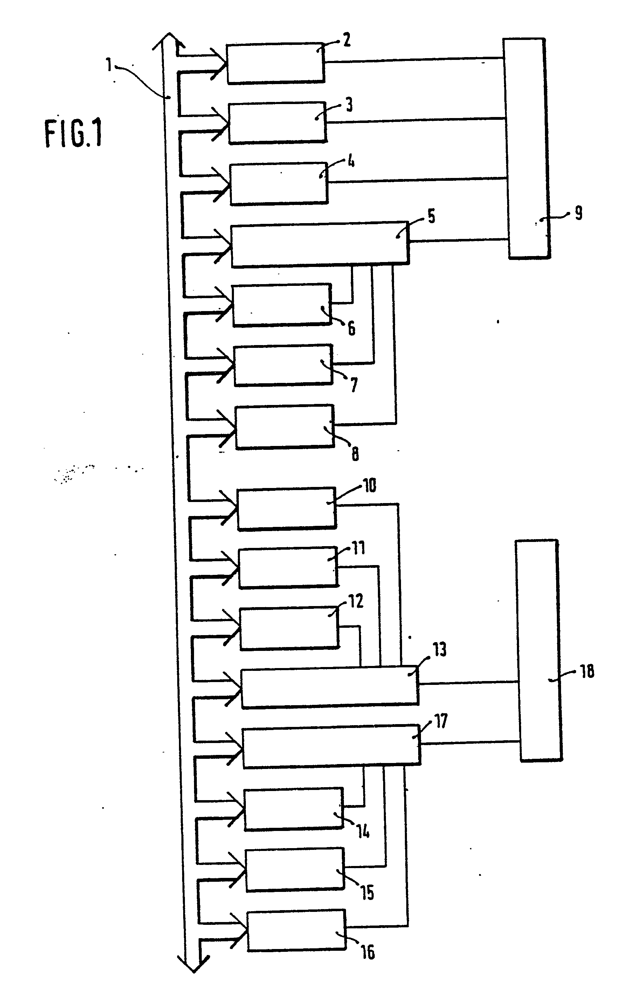

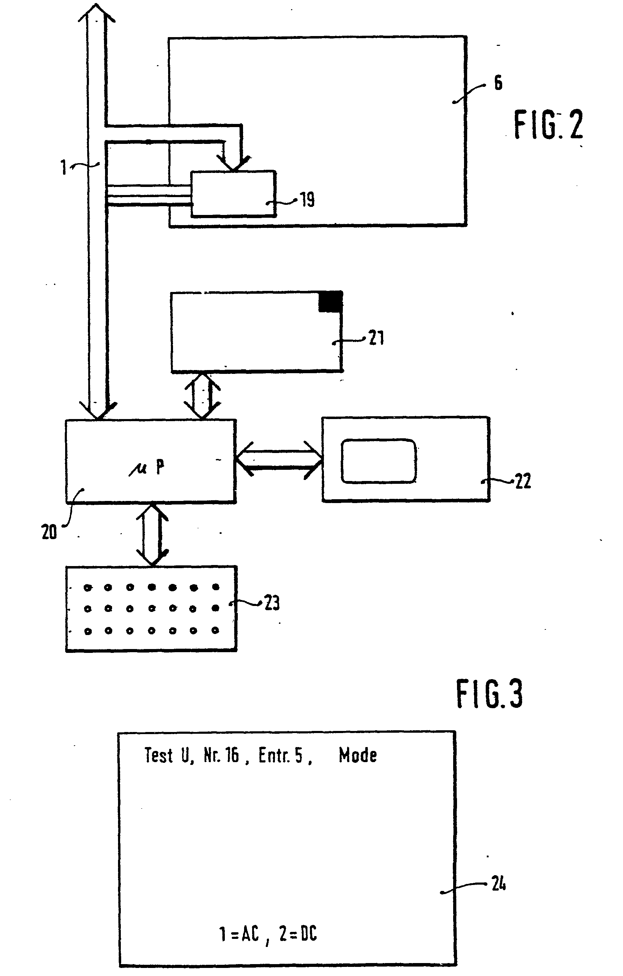

Zeichnung
Ein Ausführungsbeispiel der Erfindung ist in
der Zeichnung dargestellt und in der nachfolgenden Beschreibung näher erläutert. Es zeigen Fig. 1 die Baugruppen mit dem Koppelfeld und dem
Prüfstecker, Fig. 2 die Recheneinheit und Fig. 3
ein Beispiel für die Anzeigeeinheit.

Beschreibung des Ausführungsbeispiels:
Fig. 1 zeigt die Anordnung der Baugruppen
und ihre Zusammenfassung durch Koppelfelder.
Das Prüfsystem weist einen Adress- und Datenbus 1 auf, der sich durch das gesamte Gerät zieht.
Der Adress- und Datenbus 1 ist an Steckkontakte
angeschlossen, in die Leiterplatten einsteckbar
sind. Eine jede Leiterplatte ist als Baugruppe ausgeführt. Mit dem Adress-und Datenbus 1 stehen
digitale Baugruppen 2 bis 4 in Verbindung. Die
Ausgänge der digitalen Baugruppen 2 bis 4 führen zum Prüfstecker 9. Weiterhin ist ein Koppelfeld 5 vorhanden, das ebenfalls mit dem Adress-
und Datenbus 1 in Verbindung steht. Analoge
Baugruppen 6 bis 8 stehen einerseits mit dem
Adress- und Datenbus 1, andererseits mit dem
Koppelfeld 5 in Verbindung. Der Ausgang des
Koppelfeldes 5 führt zu dem Prüfstecker 9. Darunter sind weitere Baugruppen 10 bis 12 und 14
bis 16 aufgezeigt, die einerseits mit dem Adress-
und Datenbus 1, andererseits mit dem Koppelfeld
13 bzw. 17 verbunden sind. Die Koppelfelder sind
ebenfalls mit dem Adress- und Datenbus 1 verbunden. Der Ausgang der Koppelfelder 13 und
17 führt zu einem Prüfstecker 18.

Mit diesem Prüfsystem ist die Prüfung von
elektrischen Bauelementen, Schaltgruppen und
Geräten möglich. Das Prüfsystem selbst besteht
aus einer Vielzahl von Mess- und Stimuliergeräten, die zur Überprüfung notwendig sind. Als
Messgeräte kommen beispielsweise Spannungs-
und Strommesser, Frequenzzähler oder Ohmmeter in Betracht. Als Stimuliergeräte finden Sinus-
oder Rechteckgeneratoren, Rampengeneratoren,
Pegelwandler oder Impulsgeber Verwendung.
Die Anzahl und die Art der Geräte richtet sich
nach der zu lösenden Aufgabe. Die einzelnen Geräte sind in Form von Baugruppen aufgebaut, die
an beliebiger Stelle im Prüfsystem steckbar sind.
Die Baugruppen sind zu diesem Zweck mechanisch und an den elektrischen Schnittstellen mit
dem Adress- und Datenbus identisch aufgebaut,
so dass eine sinnvolle Aneinanderreihung der
Baugruppen, die untereinander Informationen
und Daten über den Adress- und Datenbus austauschen können, möglich ist. Die Baugruppen
können entweder mit digitalen oder mit analogen
Schaltungen bestückt sein. Die Ausgänge der
Baugruppen sind entweder direkt oder über ein
Koppelfeld mit den Prüfsteckern 9 und 18 verbunden. Die Art der Verbindung richtet sich nach
dem jeweiligen Anwendungsfall. Ist eine bestimmte Gruppe von Steckkontakten immer mit
denselben Punkten des Prüfsteckers zu verbinden, so ist eine direkte Verbindung der einzelnen
Baugruppen mit dem Prüfstecker vorteilhaft. Dies
ist bei den Baugruppen 2 bis 4 realisiert, die direkt
mit dem Prüfstecker verbunden sind. Eine solche
Verbindung eignet sich beispielsweise für die
Stromversorgung von Prüflingen oder für digitale
Signale. Ist jedoch der Prüfstecker unterschiedlichen Aufgaben jeweils neu anzupassen, ist die Zwischenschaltung eines Koppelfeldes 5, 13, 17 vorteilhaft. Alle Ein- bzw. Ausgänge der Baugruppen 6 bis 8 stehen dabei in der vertikalen Linie des Koppelfeldes 5 zur Verfügung, während in der horizontalen Linie des Koppelfeldes 5 sämtliche freien Anschlüsse des Prüfsteckers 9 angeschlossen sind. Durch Kontaktgabe an entsprechenden Knotenpunkten ist nunmehr jedes Signal der Baugruppen 6 bis 8 an einen beliebigen Steckkontakt des Prüfsteckers 9 aufschaltbar. Dadurch ist der Prüfstecker jeder neuen Messaufgabe sofort anpassbar, ohne dass aufwendige Verdrahtungen vorgenommen werden müssen. Da das Koppelfeld 5, das ähnlich einem Kreuzschienenverteiler arbeitet, durch den Adress- und Datenbus 1 steuerbar ist, erfolgt die Steuerung mittels eines Rechners. Das Prüfsystem kann daher jederzeit an neue Prüfanforderungen angepasst werden.

Fig. 2 zeigt weitere Details des Prüfsystems. Es ist wiederum der Adress- und Datenbus 1 erkennbar, an den nur die eine Baugruppe 6 angeschlossen ist. Weitere anschliessbare Baugruppen sind in der Fig. nicht dargestellt. Die Baugruppe 6 weist eine Dekodiereinheit 19 auf, die durch den Adress- und Datenbus 1 ansprechbar ist und an diesen Signale zurückgibt. An den Adress- und Datenbus 1 ist des weiteren ein Rechnerbaustein 20 angeschlossen, der mit einem Speicher 21 verbunden ist. Der Rechnerbaustein 20 ist durch eine Tastatur 23 von aussen ansteuerbar. Ein Sichtgerät 22 dient zur Anzeige der im Rechner enthaltenen Informationen. Das gesamte Prüfsystem wird durch den Rechner 20 gesteuert. Die dabei notwendigen Befehle werden über die Tastatur 23 eingegeben.

Um die vorhandene Systemkonfiguration des Prüfsystems festzustellen, sendet der Rechner 20 der Reihe nach Adressen aus. Einem bestimmten Steckplatz ist dabei eine ganz bestimmte Adresse vorgegeben. Wird nun der Steckplatz der Baugruppe 6 angesprochen, so wird der Kodierer 19 durch die Adress- und Datenleitung 1 aktiviert und sendet seinerseits ein Datenwort aus, aufgrund dessen der Rechner erkennen kann, welche Art von Baugruppe an dieser Stelle eingesteckt ist. Wird beispielsweise durch das Anliegen einer geeigneten Adresse der Steckplatz 1 angesprochen, dann wird das Datenwort dieses Steckplatzes ausgelesen. Liegt an keinem der entsprechenden Datenbits ein Signal an, so bedeutet dies, dass dieser Steckplatz nicht belegt ist. Dem letzten Datenbit kommt in diesem Ausführungsbeispiel eine besondere Bedeutung zu. Ist dieses Datenbit eine logische 1, so bedeutet dies, dass ein von der Baugruppe beim Einschalten durchgeführter Eigentest positiv beendet wurde. Die Baugruppe ist somit in Ordnung. Liegt eine logische 0 an, so ist die Baugruppe nicht voll funktionsfähig. Die Anzahl der notwendigen Adress- und Datenbits richtet sich nach der maximalen Ausbaustufe des Prüfsystems. Die Übertragung der Daten kann parallel oder seriell erfolgen, wobei der parallelen Übertragung wegen der schnelleren Übertragungszeit der Vorteil zu geben ist. Die dadurch ermittelten Daten werden durch den Rechner 20 in einem RAM abgelegt und dienen zur Steuerung des Prüfsystems.

Die Steuerbefehle werden über die Tastatur 23 dem Rechner 20 eingegeben und auf einem Bildschirm 22 oder einem Drucker ausgegeben. Den Tasten werden dabei durch die Kodierung die zu dem entsprechenden Zeitpunkt der Baugruppen beim Aufruf einer Baugruppe bestimmten Funktionen durch den Rechner 20 zugewiesen.

Die Fig. 3 zeigt hierzu ein Beispiel. Ist das Prüfsystem im Ruhezustand, wird angezeigt, welche Funktionen programmierbar sind. Dies kann beispielsweise die Messung einer Spannung oder eines Stromes sein oder aber auch die Ausgabe von Impulsen. Wird nun beispielsweise durch Tastendruck ausgewählt, dass eine Messung durchgeführt werden soll, erscheint auf dem Bildschirm «$_{Test}$». Wird nun durch Tastendruck die Spannung ausgewählt, erscheint ein U (für Spannungsmessung) auf dem Bildschirm 24 des Sichtgerätes 22. Als nächste Grösse wird angegeben, auf welchem Steckplatz die Baugruppe eingebaut ist, die eine Spannungsmessung ermöglicht. Im Beispiel ist dies der Steckplatz 16. Die nächste Zahl zeigt an, welcher Steckkontakt des Prüfsteckers 9 oder 18 mit dem Messeingang belegt ist. Im gezeigten Beispiel ist dies durch eine 5 dargestellt. Die Prüfsteckerbelegung ist dabei mittels der Tastatur 23 über ein Koppelfeld 5, 13, 17 änderbar. Unten auf dem Bildschirm ist dargestellt, welche Grössen weiterhin wählbar sind. Wird durch die Tastatur eine 1 eingegeben, heisst dies, dass eine Wechselspannungsmessung erfolgt, wird eine 2 eingegeben, erfolgt eine Gleichspannungsmessung. Ausser der 1 und der 2 sind andere Tasten der Tastatur 23 nicht aktiviert. Werden sie trotzdem betätigt, lösen sie keinen Befehl im Rechner 20 aus, statt dessen ertönt ein Signal, das anzeigt, dass eine falsche Taste betätigt ist. Als weitere Grösse ist nun der Spannungsbereich wählbar, soweit diese Einstellung nicht automatisch erfolgt. Die für den Rechner notwendigen Informationen sind in dem Speicher 21 abgelegt, der vorzugsweise als Festwertspeicher ausgebildet ist. In diesen Speicher können auch Texte eingegeben sein, die auf dem Bildschirm dargestellt werden und die Bedienung des Prüfsystems erleichtern. Der Speicher 21 ist steckbar ausgeführt, so dass die Systembedienung leicht umstellbar ist oder aber erläuternde Texte in der jeweiligen Landessprache darstellbar sind. Durch diese Führung des Bedienenden des Prüfsystems ergibt sich der Vorteil, dass der Bedienende keine Programmiersprache beherrschen oder Befehlssätze sowie Einstelldaten der Mess- oder Stimuli-Geräte auswendig lernen muss, sondern dass er durch das Gerät selbst geführt ist.

## Patentansprüche

1. Prüfsystem, insbesondere zum Testen elektronischer Geräte und Baugruppen, mit mehreren Baugruppen (2–8, 10–17), die in dem Prüfsystem steckbar sind, mit einem Datenbus (1), durch den Informationen von den Baugruppen (2–8, 10–17) und zu den Baugruppen (2–8, 10–17) übertragbar sind, und mit einer Rechnereinheit (20–23), dadurch gekennzeichnet, dass jede Baugruppe (2–8, 10–17) eine Codierung (19) aufweist, die durch ein Adresswort aktivierbar ist, und dass die Codierung (19) als Datenwort abfragbar ist, das die jeweilige Baugruppe (2–8, 10–17) kennzeichnet.

2. Prüfsystem nach Anspruch 1, dadurch gekennzeichnet, dass ein Koppelfeld (5, 13, 17) vorgesehen ist, mit dem alle oder ein Teil der Baugruppen (2–4, 6–8, 10–12, 14–16) verbindbar sind.

3. Prüfsystem nach Anspruch 2, dadurch gekennzeichnet, dass das Koppelfeld (5, 13, 17) steuerbar ist.

4. Prüfsystem nach Anspruch 2 oder 3, dadurch gekennzeichnet, dass zumindest ein Prüfstecker (9, 18) vorgesehen ist, der zumindest teilweise mit den Ausgängen des Koppelfeldes (5, 13, 17) verbunden ist.

5. Prüfsystem nach einem der Ansprüche 1 bis 4, dadurch gekennzeichnet, dass die Baugruppen (2–4) teilweise direkt mit dem Prüfstecker (9) verbunden sind.

6. Prüfsystem nach einem der Ansprüche 1 bis 5, dadurch gekennzeichnet, dass eine Anzeigevorrichtung (22) vorgesehen ist, die anzeigt, welche Baugruppen (2–8, 10–17) bei einer bestimmten Adresse vorhanden sind.

7. Prüfsystem nach einem der Ansprüche 1 bis 6, dadurch gekennzeichnet, dass eine Tastatur (23) vorgesehen ist, bei der mittels Tasten eine bestimmte Funktion einer bestimmten Baugruppe (2–8, 10–17) aktivierbar ist.

8. Prüfsystem nach Anspruch 7, dadurch gekennzeichnet, dass die Tasten der Tastatur (23) blockiert sind, wenn mit ihnen bei der aktivierten Baugruppe (2–8, 10–17) keine sinnvollen Funktionen auslösbar sind.

9. Prüfsystem nach Anspruch 8, dadurch gekennzeichnet, dass beim Betätigen einer blockierten Taste ein Warnsignal abgegeben wird.

10. Prüfsystem nach einem der vorhergehenden Ansprüche, dadurch gekennzeichnet, dass die Recheneinheit (20–23) einen Festwertspeicher (21) aufweist, in dem sämtliche Informationen (Adressen, Baugruppen, Funktionen der Baugruppen, Anzeige) abgespeichert sind.

11. Prüfsystem nach Anspruch 10, dadurch gekennzeichnet, dass der Festwertspeicher (21) auswechselbar ist.

12. Prüfsystem nach einem der vorhergehenden Ansprüche, dadurch gekennzeichnet, dass beim Einschalten des Prüfsystems die Baugruppen (2–8, 10–17) zumindest teilweise einen Eigentest durchführen.

13. Prüfsystem nach Anspruch 12, dadurch gekennzeichnet, dass das Ergebnis des Eigentests der Baugruppen (2–8, 10–17) auslesbar ist.

14. Prüfsystem nach einem der vorhergehenden Ansprüche, dadurch gekennzeichnet, dass beim Aufruf einer Baugruppe (2–8, 10–17) der Reihe nach die Eigenschaft, die Anordnung des Eingangs- und/oder Ausgangssignals beim Prüfstecker (9, 18), die Betriebsart und der Betriebsbereich oder Teile davon auf der Anzeigevorrichtung (22) angezeigt sind.

15. Prüfsystem nach Anspruch 14, dadurch gekennzeichnet, dass bei allen oder Teilen der angezeigten Daten mittels der Tastatur (23) eine Auswahl zu treffen ist.

## Revendications

1. Système de test, notamment pour tester des appareils et ensembles électroniques, comportant plusieurs ensembles (2–8, 10–17) pouvant être enfichés dans le système de test, un bus de données (1) par lequel des informations peuvent être transmises depuis les ensembles (2–8, 10–17) et vers les ensembles (2–8, 10–17), et une unité de calcul (20–23), caractérisé en ce que chaque ensemble (2–8, 10–17) présente un codage (19) activable par un mot d'adresse, et en ce que ce codage (19) peut être appelé en tant que mot de donnée caractérisant l'ensemble concerné (2–8, 10–17).

2. Système de test selon la revendication 1, caractérisé en ce qu'il est prévu un champ de couplage (5, 13, 17) par lequel tous les ensembles (2–4, 6–8, 10–12, 14–16), ou une partie d'entre eux, peuvent être reliés.

3. Système de test selon la revendication 2, caractérisé en ce que le champ de couplage (5, 13, 17) peut être commandé.

4. Système de test selon la revendication 2 ou 3, caractérisé en ce qu'il est prévu au moins un connecteur de test (9, 18) qui est au moins partiellement relié aux sorties du champ de couplage (5, 13, 17).

5. Système de test selon l'une des revendications 1 à 4, caractérisé en ce que les ensembles (2–4) sont en partie directement reliés au connecteur de test (9).

6. Système de test selon l'une des revendications 1 à 5, caractérisé en ce qu'il est prévu un dispositif d'affichage (22) indiquant quels ensembles (2–8, 10–17) sont présents pour une adresse déterminée.

7. Système de test selon l'une des revendications 1 à 6, caractérisé en ce qu'il est prévu un clavier (23) avec lequel une fonction déterminée d'un ensemble déterminé (2–8, 10–17) peut être activée au moyen de touches.

8. Système de test selon la revendication 7, caractérisé en ce que les touches du clavier (23) sont bloquées lorsqu'aucune fonction opportune ne peut être déclenchée par elles alors que l'ensemble (2–8, 10–17) est activé.

9. Système de test selon la revendication 8, caractérisé en ce qu'un signal d'avertissement est émis lors de l'actionnement d'une touche bloquée.

10. Système de test selon l'une des revendications précédentes, caractérisé en ce que l'unité de calcul (20–23) comporte une mémoire fixe (21) dans laquelle toutes informations (adresses, ensembles, fonctions des ensembles, affichage) sont mémorisées.

11. Système de test selon la revendication 10, caractérisé en ce que la mémoire fixe (21) est échangeable.

12. Système de test selon l'une des revendications précédentes, caractérisé en ce que, lors de la mise en circuit de ce système de test, les ensembles (2–8, 10–17) accomplissent au moins en partie un autocontrôle.

13. Système de test selon la revendication 12, caractérisé en ce que le résultat de l'autodiagnostic des ensembles (2–8, 10–17) peut être lu.

14. Système de test selon l'une des revendications précédentes, caractérisé en ce que, lorsqu'un ensemble (2–8, 10–17) est appelé à son tour, le dispositif d'affichage (22) indique la caractéristique propre, l'emplacement du signal d'entrée et/ou de sortie dans le connecteur de test (9, 18), le type de fonctionnement et la plage de fonctionnement, ou des parties de tels renseignements.

15. Système de test selon la revendication 14, caractérisé en ce que, pour la totalité ou une partie des données affichées, un choix peut être fait au moyen du clavier (23).

## Claims

1. Test system, particularly for testing electronic instruments and assemblies, comprising several assemblies (2–8, 10–17) which can be plugged in in the test system, including a data bus (1) by means of which data can be transmitted from the assemblies (2–8, 10–17) and to the assemblies (2–8, 10–17), and including a computer unit (20–23), characterised in that each assembly (2–8, 10–17) has a coding (19) which can be activated by an address word an that the coding (19) can be interrogated as data word which characterises the respective assembly (2–8, 10–17).

2. Test system according to Claim 1, characterised in that a switching matrix (5, 13, 17) is provided to which all or a part of the assemblies (2–4, 6–8, 10–12, 14–16) can be connected.

3. Test system according to Claim 2, characterised in that the switching matrix (5, 13, 17) is controllable.

4. Test system according to Claim 2 or 3, characterised in that at least one test plug (9, 18) is provided which is connected at least partially to the outputs of the switching matrix (5, 13, 17).

5. Test system according to one of Claims 1 to 4, characterised in that the assemblies (2–4) are partially directly connected to the test plug (9).

6. Test system according to one of Claims 1 to 5, characterised in that a display device (22) is provided which indicates which assemblies (2–8, 10–17) are present at a certain address.

7. Test system according to one of Claims 1 to 6, characterised in that a keyboard (23) is provided on which a certain function of a certain assembly (2–8, 10–17) can be activated by means of keys.

8. Test system according to Claim 7, characterised in that the keys of the keyboard (23) are blocked if they cannot be used to enable meaningful functions in the activated assembly (2–8, 10–17).

9. Test system according to Claim 8, characterised in that a warning signal is produced if a blocked key is operated.

10. Test system according to one of the preceding Claims, characterised in that the computer unit (20–23) has a read-only memory (21) in which all data (addresses, assemblies, functions of assemblies, display) are stored.

11. Test system according to Claim 10, characterised in that the read-only memory (21) is interchangeable.

12. Test system according to one of the preceding Claims, characterised in that when the test system is switched on, the assemblies (2–8, 10–17) conduct, at least partially, a self test.

13. Test system according to Claim 12, characterised in that the result of the self test of the assemblies (2–8, 10–17) can be read out.

14. Test system according to one of the preceding Claims, characterised in that when an assembly (2–8, 10–17) is called up, the characteristic, the arrangement of the input and/or output signal at the test plug (9, 18), the operating mode and the operating range or parts thereof are sequentially indicated on the display device (22).

15. Test system according to Claim 14, characterised in that a selection must be made by means of the keyboard (23) with all or parts of the data displayed.

FIG.1

FIG. 2

FIG. 3

Test U, Nr. 16, Entr. 5, Mode

1 = AC , 2 = DC

9